# EUROPÄISCHE PATENTSCHRIFT

(11) **EP 3 239 745 B1**
(45) Veröffentlichungstag und Bekanntmachung des Hinweises auf die Patenterteilung: **01.01.2020**
(21) Anmeldenummer: 17167326.2
(22) Anmeldetag: 20.04.2017
(51) Int. Cl.: G02B 5/08, G03F 7/20, G21K 1/06

(54) **SPIEGEL ZUR REFLEXION VON EUV-STRAHLUNG MIT SPANNUNGSKOMPENSATION UND VERFAHREN ZU DESSEN HERSTELLUNG**
MIRROR FOR REFLECTING EUV RADIATION WITH TENSION COMPENSATION AND METHOD FOR PRODUCING THE SAME
MIROIR DE RÉFLEXION DE RAYON EUV À COMPENSATION DE TENSION ET SON PROCÉDÉ DE FABRICATION

(30) Priorität: 29.04.2016 DE 102016107969
(43) Veröffentlichungstag der Anmeldung: 01.11.2017
(73) Patentinhaber: Fraunhofer-Gesellschaft zur Förderung der angewandten Forschung e.V., 80686 München (DE)
(72) Erfinder: Naujok, Philipp, 07745 Jena (DE); Murray, Kevin, 07745 Jena (DE); Yulin, Sergiy, 07745 Jena (DE); Kaiser, Norbert, 07745 Jena (DE)
(74) Vertreter: Epping - Hermann - Fischer

(56) Entgegenhaltungen:
- WO-A1-2010/031483
- WO-A1-2010/091907
- MIRIAM BARTHELMESS AND SASA BAJT: "Thermal and stress studies of normal incidence Mo/B4C multilayers for a 6.7 nm wavelength", APPLIED OPTICS, OPTICAL SOCIETY OF AMERICA, WASHINGTON, DC; US, Bd. 50, Nr. 11, 10. April 2011 (2011-04-10), Seiten 1610-1619, XP001561739, ISSN: 0003-6935, DOI: 10.1364/AO.50.001610 [gefunden am 2011-04-07]
- IGOR A. MAKHOTKIN ET AL: "Wavelength selection for multilayer coatings for the lithography generation beyond EUVL", PROCEEDINGS OF SPIE, vol. 8322, 13 March 2012 (2012-03-13), page 832213, XP055503204, 1000 20th St. Bellingham WA 98225-6705 USA ISSN: 0277-786X, DOI: 10.1117/12.918036 ISBN: 978-1-5106-1533-5

## Beschreibung

Die Erfindung betrifft ein Verfahren zur Herstellung eines Spiegels, der zur Reflexion von extrem ultravioletter Strahlung (EUV-Strahlung) geeignet ist.

Der Spiegel kann insbesondere zur Reflexion von EUV-Strahlung mit einer Wellenlänge zwischen 6 nm und 15 nm vorgesehen sein. Von besonderer praktischer Bedeutung sind insbesondere die Wellenlängen von etwa 13,5 nm und etwa 6,7 nm, da diese Wellenlängen für die EUV-Lithographie (EUVL, Extreme Ultraviolet Lithography) bzw. die nächste Generation der EUV-Lithographie (BEUVL, Beyond Extreme Ultraviolet Lithography) eingesetzt werden könnten.

Spiegel für EUV-Strahlung können durch Dünnschichtsysteme realisiert werden, die eine in der Regel periodische Schichtenfolge aus einer Vielzahl von Schichtpaaren enthalten. Ein Schichtpaar enthält im Allgemeinen zwei Schichten aus verschiedenen Materialien, die in dem zur Verwendung des Bauelements vorgesehenen Wellenlängenbereich einen möglichst großen Unterschied in ihren optischen Konstanten aufweisen sollten. Die Auswahl der Materialien für die Schichtenfolge ist daher vor allem von der Wellenlänge, bei der Spiegel verwendet werden soll, abhängig. Im EUV-Spektralbereich gibt es daher für jeweils einen bestimmten, meist nur wenige Nanometer breiten Wellenlängenbereich eine optimale Materialpaarung, welche aufgrund des optischen Kontrastes der Schichtmaterialien eine hohe Reflexion garantiert.

Bei der Herstellung von EUV-Spiegeln kann es durch intrinsische Druckspannungen in der Schichtenfolge zur Verformung dieser kommen. Die Veränderung der Oberflächenmorphologie kann die Funktion eines optischen Elements, wie etwa eines Kollektorspiegels, derart einschränken, dass die geforderte Präzision nicht mehr eingehalten werden kann oder das optische Element seine Wirkung gänzlich verliert.

In der Druckschrift WO 2010/031483 A1 wird beschrieben, dass die resultierende Spannung in einem Multilayer-Schichtsystem unter anderem von den Materialien des Spacers und des Absorbers sowie deren Schichtdicken, insbesondere vom Γ-Wert (Verhältnis der Dicke des Absorbers zur Periode) abhängt. Es wird vorgeschlagen, zwei Mo/Si-Multilayer mit verschiedenen Γ-Werten derart übereinander abzuscheiden, dass sich die Spannungen kompensieren.

Die Druckschrift WO2010/091907 A1 beschreibt Multilayer-Spiegel für den Spektralbereich von 2 nm bis 8 nm und geeignete Materialkombinationen für diesen Spektralbereich.

Eine zu lösende Aufgabe besteht darin, ein verbessertes Verfahren zur Herstellung eines Spiegels zur Reflexion von EUV-Strahlung anzugeben, der sich durch verringerte Spannungen auszeichnet.

Diese Aufgabe wird durch ein Verfahren gemäß dem unabhängigen Patentanspruch gelöst. Vorteilhafte Ausgestaltungen und Weiterbildungen der Erfindung sind Gegenstand der abhängigen Ansprüche.

Bei der Herstellung des Spiegels wird in einem ersten Schritt die spannungskompensierende Schichtenfolge auf ein Substrat aufgebracht, wobei die spannungskompensierende Schichtenfolge abwechselnde erste Schichten aus Bor, einem Bornitrid, einem Borcarbid oder einem Boroxid und zweite Schichten aus Lanthan, einem Lanthannitrid, einem Lanthancarbid oder einem Lanthanoxid aufweist. Nach dem Aufbringen auf das Substrat weist die spannungskompensierende Schichtenfolge mit den abwechselnden ersten Schichten und zweiten Schichten aus den genannten Materialien zunächst eine Druckspannung auf.

In einem nachfolgenden Schritt wird eine Temperaturbehandlung in einem Temperaturbereich zwischen 100 °C und 800 °C, vorzugsweise zwischen 400 °C und 800°C, durchgeführt. Durch die Temperaturbehandlung wird die Druckspannung in der spannungskompensierenden Schichtenfolge abgebaut und eine Zugspannung erzeugt. Die Dauer der Temperaturbehandlung beträgt vorzugsweise mindestens 2 h, beispielsweise zwischen 2 h und 10 h.

Nach der Durchführung der Temperaturbehandlung wird die reflektierende Schichtenfolge, die abwechselnde dritte Schichten und vierte Schichten aufweist, über der spannungskompensierenden Schichtenfolge aufgebracht. Die dritten Schichten und vierten Schichten können insbesondere die gleichen Materialien aufweisen wie die ersten Schichten und zweiten Schichten der spannungskompensierenden Schichtenfolge.

Beim Aufbringen der reflektierenden Schichtenfolge wird eine Druckspannung erzeugt, die durch die zuvor mittels der thermischen Behandlung in der spannungskompensierenden Schichtenfolge erzeugte Zugspannung reduziert oder kompensiert wird.

Bei einer Ausgestaltung des Verfahrens wird nach der Temperaturbehandlung und vor dem Aufbringen der reflektierenden Schichtenfolge eine Zwischenschicht auf die spannungskompensierende Schichtenfolge aufgebracht. Die Zwischenschicht weist vorzugsweise Bor, ein Bornitrid, ein Borcarbid, ein Boroxid oder Kohlenstoff auf, und die Dicke der Zwischenschicht beträgt vorzugsweise zwischen 10 nm und 200 nm.

Der mit dem Verfahren herstellbare Spiegel ist zur Reflexion von EUV-Strahlung, insbesondere im Spektralbereich zwischen 6 nm und 15 nm, vorgesehen. Bei einer vorteilhaften Ausgestaltung ist der Spiegel zur Reflexion von Strahlung im Wellenlängenbereich zwischen 6 nm und 7 nm, insbesondere bei etwa 6,7 nm, vorgesehen. Bei einer anderen vorteilhaften Ausgestaltung ist der Spiegel zur Reflexion von Strahlung im Wellenlängenbereich zwischen 13 nm und 14 nm, insbesondere bei etwa 13,5 nm, vorgesehen.

Der Spiegel umfasst gemäß zumindest einer Ausgestaltung mindestens eine auf einem Substrat angeordnete spannungskompensierende Schichtenfolge, die abwechselnde erste Schichten und zweiten Schichten aufweist. Die ersten Schichten weisen vorteilhaft Bor, ein Bornitrid, ein Borcarbid oder ein Boroxid auf. Die zweiten Schichten weisen vorteilhaft Lanthan, ein Lanthannitrid, ein Lanthancarbid oder ein Lanthanoxid auf.

Die spannungskompensierende Schichtenfolge weist eine Zugspannung auf. Die Zugspannung in der spannungskompensierende Schichtenfolge wird bei der Herstellung durch eine thermische Behandlung, die im Folgenden im Zusammenhang mit dem erfindungsgemäßen Verfahren noch näher erläutert wird, erzeugt. Es hat sich herausgestellt, dass sich durch die thermische Behandlung der Schichtenfolge aus den ersten und zweiten Schichten der genannten Materialien eine Zugspannung erzeugen lässt, welche insbesondere durch die Dauer und die Temperatur bei der Temperaturbehandlung gezielt einstellbar ist. Weiterhin haben die genannten Materialien den Vorteil, dass die Schichtenfolge durch die Temperaturbehandlung nicht derart beeinträchtigt wird, dass ein Aufwachsen des Spiegels aufgrund der verminderten Oberflächenqualität nicht mehr möglich wäre.

Über der spannungskompensierenden Schichtenfolge ist in dem Spiegel eine reflektierende Schichtenfolge angeordnet, die abwechselnde dritte Schichten und vierte Schichten aufweist, wobei die reflektierende Schichtenfolge eine Druckspannung aufweist. Die Schichtdicken und Materialien der dritten und vierten Schichten sind vorteilhaft so ausgewählt, dass bei der Wellenlänge, bei der der Spiegel ein Reflexionsmaximum aufweisen soll, eine möglichst hohe Reflektivität aufweist. Bei einer bevorzugten Ausgestaltung weist die reflektierende Schichtenfolge einen Schichtenstapel auf, der mehrere Schichtpaare aufweist. Die Schichtpaare enthalten jeweils die dritte Schicht und die vierte Schicht und können insbesondere jeweils nur aus der dritten Schicht und der vierten Schicht bestehen. Die reflektierende Schichtenfolge kann insbesondere eine periodische Schichtenfolge sein, bei dem die Schichtpaare jeweils die gleiche Dicke (Periodendicke) aufweisen.

Das hier beschriebene Verfahren macht sich die Erkenntnis zu Nutze, dass beim Aufbringen der reflektierenden Schichtenfolge des Spiegels typischerweise eine Druckspannung in der reflektierenden Schichtenfolge entsteht. Eine solche Druckspannung kann beim Aufbringen der reflektierenden Schichtenfolge auf ein ebenes Substrat zu einer konvexen Verbiegung führen, wenn keine geeigneten Gegenmaßnahmen getroffen werden. Die in der reflektierenden Schichtenfolge vorhandene Druckspannung wird bei dem hierin beschriebenen Spiegel vorteilhaft durch die spannungskompensierende Schichtenfolge, die eine Zugspannung, also eine Spannung mit umgekehrten Vorzeichen, aufweist, reduziert oder sogar ganz kompensiert. Die gesamte Spannung in dem Spiegel ist daher vorteilhaft geringer als bei einem direkten Aufbringen der reflektierenden Schichtenfolge auf das Substrat. Auf diese Weise wird einer Verbiegung des Substrats durch mechanische Spannungen in dem Spiegel entgegengewirkt.

Vorzugsweise sind die Zugspannung in der spannungskompensierenden Schichtenfolge und die Druckspannung in der reflektierenden Schichtenfolge zumindest näherungsweise gleich groß, so dass sie sich im Wesentlichen gegenseitig kompensieren. Auf diese Weise kann erreicht werden, dass die resultierende Kraft auf das Substrat gering oder sogar gleich Null ist.

Die in der spannungskompensierenden Schichtenfolge durch eine thermische Behandlung erzeugte Spannung kann insbesondere durch die Anzahl der Schichtpaare und die Dicken der ersten und zweiten Schichten beeinflusst werden. Die spannungskompensierende Schichtenfolge weist vorzugsweise zwischen 10 und 400 Schichtpaare der ersten Schichten und zweiten Schichten auf. Die ersten Schichten und zweiten Schichten weisen vorteilhaft jeweils eine Dicke zwischen 1 nm und 10 nm auf.

Die abwechselnden dritten Schichten und vierten Schichten der reflektierenden Schichtenfolge können bei einer vorteilhaften Ausgestaltung aus den gleichen Materialien gebildet sein wie die abwechselnden ersten Schichten und zweiten Schichten der spannungskompensierende Schichtenfolge.

Insbesondere können die dritten Schichten Bor, ein Bornitrid, ein Borcarbid oder ein Boroxid aufweisen, und die vierten Schichten können Lanthan, ein Lanthannitrid, ein Lanthancarbid oder ein Lanthanoxid aufweisen. Aufgrund der optischen Konstanten der Bor enthaltenden Materialien der dritten Schichten und der Lanthan enthaltenden Materialien der vierten Schichten kann mit diesen Materialkombinationen in den Schichtpaaren eine vorteilhaft hohe Reflexion im EUV-Spektralbereich von 6 nm bis 10 nm erzielt werden. Der Spiegel kann insbesondere ein Reflexionsmaximum im Wellenlängenbereich zwischen 6 nm und 10 nm, vorzugsweise zwischen 6 nm und 7 nm und besonders bevorzugt bei 6,7 nm aufweisen. Die Verwendung der gleichen Schichtmaterialien in der spannungskompensierenden Schichtenfolge und in der reflektierenden Schichtenfolge hat den Vorteil, dass der Herstellungsaufwand für den Spiegel besonders gering ist.

Bei einer vorteilhaften Ausgestaltung des Verfahrens ist zwischen der spannungskompensierenden Schichtenfolge und der reflektierenden Schichtenfolge eine Zwischenschicht angeordnet. Die Dicke der Zwischenschicht beträgt bevorzugt zwischen 10 nm und 200 nm. Besonders geeignete Materialien für die Zwischenschicht sind Bor, ein Bornitrid, ein Borcarbid ein Boroxid oder Kohlenstoff.

Die Zwischenschicht kann insbesondere die Funktion einer Glättungsschicht haben, durch die die Oberfläche der spannungskompensierenden Schichtenfolge nach der thermischen Behandlung bei der Herstellung geglättet wird. Vorzugsweise weist die Zwischenschicht eine rms-Rauheit von nicht mehr als 0,2 nm auf. Die reflektierende Schichtenfolge wird bei der Herstellung des Spiegels vorteilhaft direkt auf die Oberfläche der Zwischenschicht aufgewachsen. Die Zwischenschicht stellt somit eine besonders glatte Aufwachsoberfläche für die nachfolgende reflektierende Schichtenfolge bereit, um die reflektierende Schichtenfolge in hoher Qualität herstellen zu können. Die reflektierende Schichtenfolge kann auf der Zwischenschicht insbesondere in ähnlich hoher Qualität hergestellt werden wie beim direkten Aufbringen auf ein qualitativ hochwertiges Substrat. Die Qualität der reflektierenden Schichtenfolge wird somit durch die zuvor auf das Substrat aufgebrachte spannungskompensierende Schichtenfolge im Wesentlichen nicht beeinträchtigt.

Bei einer weiteren vorteilhaften Ausgestaltung des Verfahrens ist zwischen den ersten Schichten und dem zweiten Schichten der spannungskompensierenden Schichtenfolge jeweils eine Barriereschicht angeordnet, wobei die Barriereschicht Kohlenstoff, Molybdän, Ruthenium, Zirkon oder ein Oxid, Nitrid oder Carbid von Molybdän, Ruthenium oder Zirkon aufweist. Die Barriereschichten sind vorteilhaft sehr dünne Schichten, deren Dicke zwischen 0,1 nm und 0,3 nm beträgt. Die dünnen Barriereschichten vermindern insbesondere eine Diffusion zwischen den ersten Schichten und zweiten Schichten der spannungskompensierenden Schichtenfolge.

Die Erfindung wird im Folgenden anhand von Beispielen im Zusammenhang mit den Figuren 1 bis 4 näher erläutert.

Es zeigen:
- Figur 1: eine schematische Darstellung eines mit dem Verfahren herstellbaren Spiegels für EUV-Strahlung gemäß einem ersten Beispiel,
- Figur 2: eine grafische Darstellung der gemessenen Spannung σ in der spannungskompensierenden Schichtenfolge gemäß einem Beispiel nach 10 h Temperaturbehandlung für verschiedene Temperaturen T,
- Figuren 3A bis 3D: eine schematische Darstellung eines Auführungsbeispiels des Verfahrens zur Herstellung des Spiegels für EUV-Strahlung anhand von Zwischenschritten, und
- Figur 4: eine schematische Darstellung eines mit dem Verfahren herstellbaren Spiegels für EUV-Strahlung gemäß einem weiteren Beispiel.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

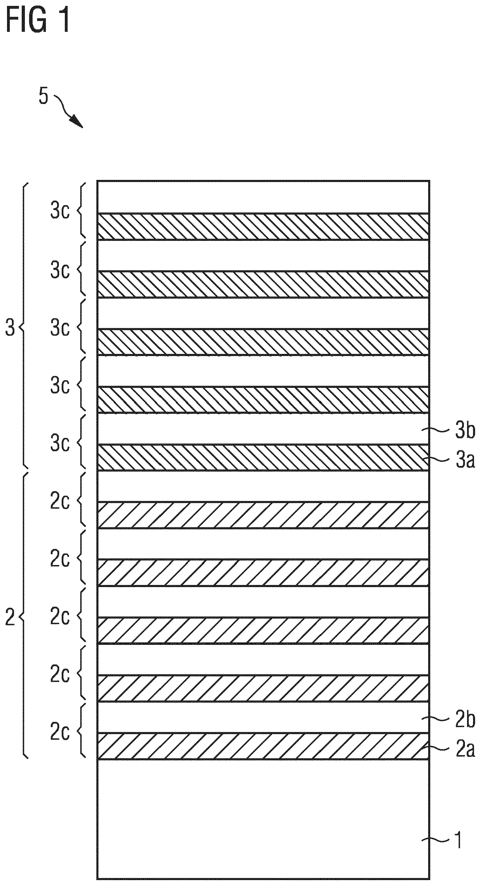

Der in Figur 1 schematisch im Querschnitt dargestellte Spiegel 5 für EUV-Strahlung weist ein Substrat 1, eine auf dem Substrat angeordnete spannungskompensierende Schichtenfolge 2 und eine über der spannungskompensierenden Schichtenfolge 2 angeordnete reflektierende Schichtenfolge 3 auf.

Das Substrat 1 kann insbesondere ein Grundkörper eines strahlformenden optischen Elements für EUV-Strahlung sein. Die Oberfläche des Substrats 1 kann eben oder gekrümmt sein. Das Substrat 1 wird vorzugsweise vor einer Beschichtung mit der spannungskompensierenden Schichtenfolge 2 gemäß den Anforderungen der Anwendung des Spiegels 5 hinsichtlich der Oberflächenform und Oberflächenrauheit bearbeitet. Die Beschichtung des Substrats 1 mit der spannungskompensierenden Schichtenfolge 2 und der reflektierenden Schichtenfolge 3 kann insbesondere durch Sputtern erfolgen, wobei alternativ aber auch andere Beschichtungsverfahren eingesetzt werden können.

Die vorzugsweise unmittelbar auf das Substrat 1 aufgebrachte spannungskompensierende Schichtenfolge 2 weist eine Vielzahl von Schichtpaaren 2c auf, wobei die Schichtpaare 2c jeweils eine erste Schicht 2a und eine zweite Schicht 2b aufweisen. Zur Vereinfachung der Darstellung sind in Figur 1 nur fünf Schichtpaare 2c dargestellt, wobei die tatsächliche Anzahl der Schichtpaare wesentlich größer sein kann. Bevorzugt beträgt die Anzahl der Schichtpaare 2c in der spannungskompensierenden Schichtenfolge 2 zwischen 10 und 400.

Die Schichtpaare 2c weisen jeweils eine erste Schicht 2a auf, die vorzugsweise Bor (B), ein Bornitrid (BNₓ), ein Borcarbid (BCₓ) oder ein Boroxid (BOₓ) aufweist. Weiterhin weisen die Schichtpaare 2c jeweils eine zweite Schicht 2b auf, die Lanthan (La), ein Lanthannitrid (LaNₓ), ein Lanthancarbid (LaCₓ) oder ein Lanthanoxid (LaOₓ) aufweist. Die Dicke der ersten Schichten 2a und der zweiten Schichten 2b beträgt vorzugsweise jeweils zwischen 1 nm und 10 nm.

Vom Substrat 1 aus gesehen über der spannungskompensierenden Schichtenfolge 2 ist eine reflektierende Schichtenfolge 3 angeordnet, die wie die spannungskompensierende Schichtenfolge 2 vorteilhaft aus einer Vielzahl von Schichtpaaren 3c gebildet ist. Wiederum sind zur Vereinfachung der Darstellung nur fünf Schichtpaare 3c dargestellt, wobei die tatsächliche Anzahl der Schichtpaare 3c aber größer sein kann. Die Anzahl der Schichtpaare 3c der reflektierenden Schichtenfolge 3 in dem EUV-Spiegel 5 kann beispielsweise zwischen 10 und 400 betragen.

Die Schichtpaare 3c der reflektierenden Schichtenfolge 3 weisen jeweils eine dritte Schicht 3a und eine vierte Schicht 3b auf. Die Materialien der reflektierenden Schichtenfolge 3 werden anhand deren optischen Konstanten bei der vorgesehenen EUV-Wellenlänge so ausgewählt, dass eine hohe Reflexion erzielt werden kann. Im Fall einer vorgesehenen Wellenlänge zwischen etwa 13 nm und 14 nm, beispielsweise etwa 13,5 nm, kann die reflektierende Schichtenfolge 3 beispielsweise abwechselnde dritte Schichten 3a aus Molybdän und vierte Schichten 3b aus Silizium aufweisen.

Bei einer bevorzugten Ausgestaltung weist der EUV-Spiegel ein Reflexionsmaximum im Wellenlängenbereich zwischen 6 nm und 10 nm, vorzugsweise zwischen 6 nm und 7 nm und besonders bevorzugt bei 6,7 nm auf. In diesem Wellenlängenbereich sind vorteilhaft die zuvor für die spannungskompensierende Schichtenfolge 2 genannten Materialien aufgrund ihrer optischen Konstanten auch dazu geeignet, die reflektierende Schichtenfolge 3 auszubilden. Die Schichtpaare 3c weisen bei dieser Ausgestaltung vorteilhaft jeweils eine dritte Schicht 3a auf, die vorzugsweise Bor (B), ein Bornitrid (BNₓ), ein Borcarbid (BCₓ) oder ein Boroxid (BOₓ) aufweist. Weiterhin weisen die Schichtpaare 3c jeweils eine vierte Schicht 3b auf, die Lanthan (La), ein Lanthannitrid (LaNₓ), ein Lanthancarbid (LaCₓ) oder ein Lanthanoxid (LaOₓ) aufweist. Es ist insbesondere möglich, dass die spannungskompensierende Schichtenfolge 2 und die reflektierende Schichtenfolge 3 des EUV-Spiegels aus den gleichen Materialien gebildet sind. Der Herstellungsaufwand ist in diesem Fall vorteilhaft gering.

In dem EUV-Spiegel 5 weist die spannungskompensierende Schichtenfolge 2 eine Zugspannung auf, die dazu vorgesehen ist, eine entgegengesetzte Druckspannung der reflektierenden Schichtenfolge 3 zu verringern oder vorzugsweise ganz zu kompensieren. Bei der Herstellung der reflektierenden Schichtenfolge 3 durch Abscheidung der Vielzahl von Schichtpaaren 3c entsteht in der Regel eine Druckspannung. Diese würde ohne geeignete Gegenmaßnahmen eine konvexe Verbiegung des Substrats 1 bewirken. Hierdurch könnte die Funktion eines optischen Systems, in dem der EUV-Spiegel 5 verwendet wird, beeinträchtigt werden. Bei dem hier beschriebenen EUV-Spiegel 5 wird eine solche Verbiegung durch eine Zugspannung in der spannungskompensierenden Schichtenfolge 2 verringert oder sogar ganz kompensiert.

Die Erzeugung der Zugspannung in der spannungskompensierenden Schichtenfolge 2 erfolgt durch eine thermische Behandlung nach dem Aufbringen auf das Substrat 1, bevor die reflektierende Schichtenfolge 3 aufgebracht wird. Die thermische Behandlung erfolgt bei einer Temperatur zwischen 100 °C und 800 °C, besonders bevorzugt zwischen 400 °C und 800 °C.

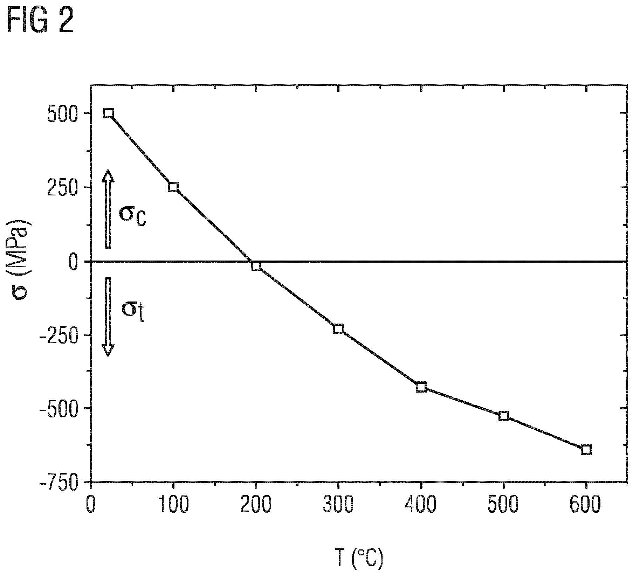

Der Einfluss der thermischen Behandlung auf die Spannung in der spannungskompensierenden Schichtenfolge 2 wird in Figur 2 anhand eines Beispiels verdeutlicht. Figur 2 zeigt die gemessene Schichtspannung σ in der spannungskompensierenden Schichtenfolge 2 nach einer Temperaturbehandlung von 10 Stunden Dauer in Abhängigkeit von der dabei verwendeten Temperatur T. Die Schichtspannung kann aus der Durchbiegung des Substrats 1 bestimmt werden. Die spannungskompensierende Schichtenfolge 2 weist bei dem Beispiel periodisch angeordnete abwechselnde ersten Schichten 2a aus Borcarbid (B₄C) und zweite Schichten 2b aus Lanthan (La) auf, wobei die Anzahl der Perioden N = 50 und die Periodendicke, d.h. die Dicke eines Schichtpaars 2c aus einer ersten Schicht 2a und einer zweiten Schicht 2b, D = 3,4 nm beträgt. Bei dem Beispiel weisen die ersten Schichten 2a und zweiten Schichten 2b ein Schichtdickenverhältnis von 1:1 auf. Die ersten Schicht 2a und die zweiten Schichten sind also jeweils 1,7 nm dick.

In Figur 2 stellen positive Werte der Schichtspannung σ eine Druckspannung σ_{c} und negative Werte eine Zugspannung σₜ dar. Nach der Herstellung weist die spannungskompensierende Schichtenfolge eine Druckspannung σ_{c} von etwa 500 MPa auf. Durch die Temperaturbehandlung kann die Druckspannung in Abhängigkeit von der Temperatur und der Dauer reduziert werden oder eine Zugspannung in der Schichtenfolge erzeugt werden. Bei der im Beispiel erfolgten Temperaturbehandlung mit einer Dauer von 10 Stunden wird die ursprünglich vorhandene Druckspannung bei einer Temperatur von etwa 200 °C vollständig abgebaut. Bei höheren Temperaturen wird eine Zugspannung erzeugt. Beispielsweise kann mit einer Temperaturbehandlung von 10 h Dauer bei 500 °C die ursprüngliche Druckspannung von etwa 500 MPa in eine entgegengesetzte Zugspannung von etwa -500 MPa umgewandelt werden.

Die Dauer und die Temperatur der thermischen Behandlung werden vorteilhaft derart eingestellt, dass eine Zugspannung erzeugt wird, welche im Wesentlichen gleich der von der reflektierenden Schichtenfolge 3 erzeugten Druckspannung ist, so dass sich die Zugspannung der spannungskompensierenden Schichtenfolge 2 und die Druckspannung der reflektierenden Schichtenfolge 3 im Wesentlichen gegenseitig kompensieren. Zur Bestimmung einer geeigneten Zugspannung kann versuchsweise die reflektierende Schichtenfolge 3 unmittelbar auf ein Substrat aufgebracht werden, um die von der reflektierenden Schichtenfolge 3 erzeugte Druckspannung anhand der dadurch erzeugten Durchbiegung des Substrats zu messen. Bei der Herstellung des EUV-Spiegels 5 wird vor der Aufbringung der effektiven Schichtenfolge 3 eine spannungskompensierende Schichtenfolge 2 aufgebracht, die eine entgegengesetzte Zugspannung gleichen Betrags aufweist. Die dazu erforderliche Temperatur kann für eine vorgegebene spannungskompensierende Schichtenfolge 2 und eine vorgegebene Dauer der Temperaturbehandlung ebenfalls experimentell ermittelt werden, insbesondere durch eine Versuchsreihe, wie sie beispielsweise in Figur 2 dargestellt ist.

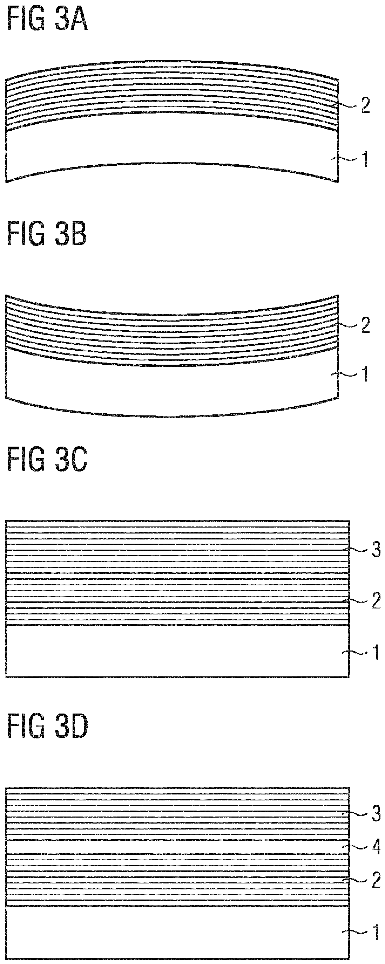

Das Verfahren zur Herstellung eines EUV-Spiegels 5 ist in den Figuren 3A bis 3D schematisch dargestellt. Wie in Figur 3A gezeigt, wird zunächst die spannungskompensierende Schichtenfolge 2 auf das Substrat 1 aufgebracht. Hierbei entsteht eine Druckspannung, die eine konvexe Durchbiegung des Substrats 1 bewirken kann.

In dem nachfolgend schematisch in Figur 3B dargestellten Verfahrensschritt erfolgt die Temperaturbehandlung, wobei die Druckspannung wie zuvor beschrieben in eine Zugspannung umgewandelt wird. Hieraus kann eine konkave Durchbiegung des Substrats 1 resultieren.

Nachfolgend wird, wie in Figur 3C dargestellt, die reflektierende Schichtenfolge 3 auf die spannungskompensierende Schichtenfolge 2 aufgebracht. Vorteilhaft kompensieren sich die bei der Herstellung der reflektierenden Schichtenfolge 3 erzeugte Druckspannung und die zuvor in der spannungskompensierenden Schichtenfolge 2 durch die Temperaturbehandlung erzeugte Zugspannung gegenseitig, so dass in dem so hergestellten EUV-Spiegel 5 keine resultierende Spannung auf das Substrat 1 einwirkt. Das Substrat 1 wird daher durch die beiden Schichtenfolgen 2, 3 des EUV-Spiegels 5 vorteilhaft nicht verformt.

Bei einer Abwandlung des Verfahrens kann vor dem Aufbringen der reflektierenden Schichtenfolge 3 eine Zwischenschicht 4 auf die spannungskompensierende Schichtenfolge 2 aufgebracht werden. Ein so hergestellter EUV-Spiegel 5 ist in Figur 3D dargestellt. Die Zwischenschicht 4 kann insbesondere die Funktion haben, auf der spannungskompensierenden Schichtenfolge 2 nach der Durchführung der Temperaturbehandlung eine möglichst glatte Oberfläche mit sehr geringer Rauheit auszubilden, um die reflektierende Schichtenfolge 3 in sehr hoher Qualität aufwachsen zu können. Vorzugsweise weist die Zwischenschicht 4 eine rms-Oberflächenrauheit von weniger als 0,2 nm auf.

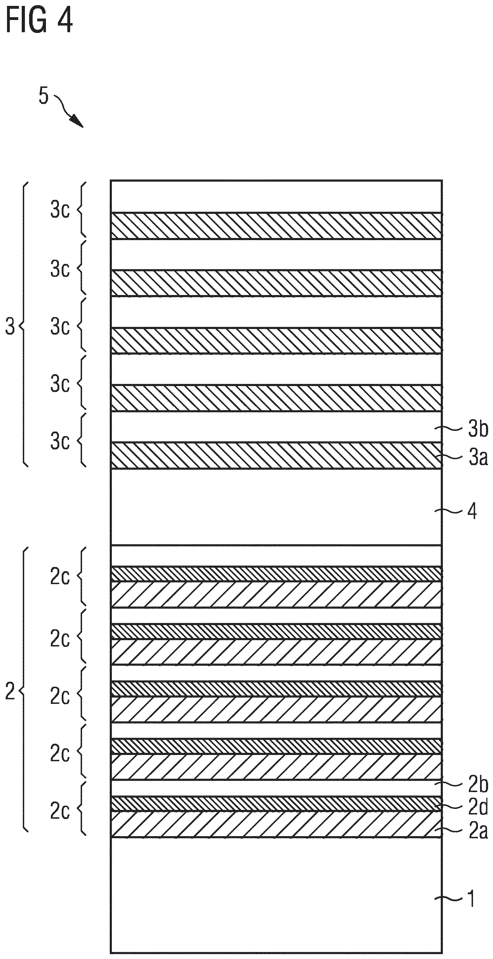

In Figur 4 ist ein weiteres Beispiel des mit dem Verfahren herstellbaren EUV-Spiegels 5 dargestellt. Dieses unterscheidet sich von dem Beispiel der Figur 1 dadurch, dass wie bei dem Beispiel der Figur 3D eine Zwischenschicht 4 zwischen der spannungskompensierenden Schichtenfolge 2 und der reflektierenden Schichtenfolge 3 angeordnet ist. Die Zwischenschicht 4 enthält vorzugsweise Bor (B), ein Bornitrid (BNₓ), ein Borcarbid (BCₓ), ein Boroxid (BOₓ) oder Kohlenstoff (C) und weist vorzugsweise eine Schichtdicke zwischen 10 nm und 200 nm auf. Es hat sich herausgestellt, dass eine Zwischenschicht 4 mit einer derartigen Schichtdicke vorteilhaft die Krümmung des Substrats nicht wesentlich beeinflusst, aber gut dazu geeignet ist, eine Oberfläche mit einer besonders geringen Oberflächenrauheit zum Aufwachsen der reflektierenden Schichtenfolge 3 zu erzeugen. Vorzugsweise weist die Zwischenschicht 4 eine rms-Oberflächenrauheit von weniger als 0,2 nm auf.

Weiterhin unterscheidet sich das Beispiel der Figur 4 von dem Beispiel der Figur 1 dadurch, dass in der spannungskompensierenden Schichtenfolge 2 zwischen den abwechselnden ersten Schichten 2a und zweiten Schichten 2b jeweils eine Barriereschicht 2d angeordnet ist. Die Barriereschichten 2d sind vorzugsweise jeweils nur 0,1 nm bis 0,3 nm dick. Bevorzugte Materialien für die Barriereschichten 2d sind Molybdän (Mo), Ruthenium (Ru), Zirkon (Zr) sowie deren Nitride, Oxide oder Carbide, sowie Kohlenstoff (C). Es hat sich herausgestellt, dass durch das Einfügen der dünnen Barriereschichten 2d der Einfluss der Temperaturbehandlung auf die Spannung in der spannungskompensierenden Schichtenfolge 2 vorteilhaft erhöht werden kann.

Hinsichtlich weiterer vorteilhafter Ausgestaltungen entspricht das Beispiel der Figur 4 ansonsten dem Beispiel der Figur 1.

### Bezugszeichenliste

- 1: Substrat
- 2: spannungskompensierende Schichtenfolge
- 2a: erste Schicht
- 2b: zweite Schicht
- 2c: Schichtpaar
- 2d: Barriereschicht
- 3: reflektierende Schichtenfolge
- 3a: dritte Schicht
- 3b: vierte Schicht
- 3c: Schichtpaar
- 4: Zwischenschicht
- 5: Spiegel

## Patentansprüche

1. Verfahren zur Herstellung eines Spiegels (5) zur Reflexion von EUV-Strahlung, umfassend die Schritte:
- Aufbringen einer spannungskompensierenden Schichtenfolge (2) auf ein Substrat (1), wobei die spannungskompensierende Schichtenfolge (2) abwechselnde erste Schichten (2a) und zweite Schichten (2b) aufweist, wobei die ersten Schichten (2a) Bor, ein Bornitrid, ein Borcarbid oder ein Boroxid aufweisen und die zweiten Schichten (2b) Lanthan, ein Lanthannitrid, ein Lanthancarbid oder ein Lanthanoxid aufweisen, und wobei die spannungskompensierende Schichtenfolge (2) nach dem Aufbringen auf das Substrat (1) eine Druckspannung aufweist,
- Durchführen einer Temperaturbehandlung im Temperaturbereich zwischen 100 °C und 800 °C, wobei durch die Temperaturbehandlung die Druckspannung abgebaut und eine Zugspannung in der spannungskompensierenden Schichtenfolge (2) erzeugt wird,
- Aufbringen einer reflektierenden Schichtenfolge (3) über der spannungskompensierenden Schichtenfolge (2), wobei die reflektierende Schichtenfolge (3) abwechselnde dritte Schichten (3a) und vierte Schichten (3b) aufweist, und wobei die reflektierende Schichtenfolge (3) eine Druckspannung aufweist.

2. Verfahren nach Anspruch 1,
wobei in dem Spiegel (5) die durch die reflektierende Schichtenfolge (3) erzeugte Druckspannung durch die in der spannungskompensierenden Schichtenfolge (2) erzeugte Zugspannung reduziert oder kompensiert wird.

3. Verfahren nach Anspruch 1 oder 2,
wobei vor dem Aufbringen der reflektierenden Schichtenfolge (3) eine Zwischenschicht (4) auf die spannungskompensierende Schichtenfolge (2) aufgebracht wird, die eine rms-Rauheit von nicht mehr als 0,2 nm aufweist.

4. Verfahren nach Anspruch 3,
wobei die Zwischenschicht (4) Bor, ein Bornitrid, ein Borcarbid, ein Boroxid oder Kohlenstoff aufweist und eine Dicke zwischen 10 nm und 200 nm aufweist.

5. Verfahren nach einem der vorhergehenden Ansprüche,
wobei die spannungskompensierende Schichtenfolge (2) zwischen 10 und 400 Schichtpaare der ersten Schichten (2a) und zweiten Schichten (2b) aufweist, und wobei die ersten Schichten (2a) und zweiten Schichten (2b) eine Dicke zwischen 1 nm und 10 nm aufweisen.

6. Verfahren nach einem der vorhergehenden Ansprüche,
wobei zwischen den ersten Schichten (2a) und den zweiten Schichten (2b) jeweils eine Barriereschicht (2d) angeordnet ist, wobei die Barriereschicht (2d) Kohlenstoff, Molybdän, Ruthenium, Zirkon oder ein Oxid, Nitrid oder Carbid von Molybdän, Ruthenium oder Zirkon aufweist, und wobei die Barriereschicht (2d) zwischen 0,1 nm und 0,3 nm dick ist.

## Claims

1. A method for producing a mirror (5) for reflecting EUV radiation, comprising the steps of:
- applying a stress compensating sequence of layers (2) onto a substrate (1), wherein the stress compensating sequence of layers (2) includes alternating first layers (2a) and second layers (2b), wherein the first layers (2a) include boron, a boron nitride, boron carbide or boron oxide, and the second layers (2b) include lanthanum, a lanthanum nitride, lanthanum carbide or lanthanum oxide, and wherein, when applied onto the substrate (1), the stress compensating sequence of layers (2) has compressive stress,
- performing a temperature treatment in the temperature range between 100° C and 800° C, wherein due to the temperature treatment, the compressive stress is reduced and tensile stress is generated in the stress compensating sequence of layers (2),
- applying a reflecting sequence of layers (3) above the stress compensating sequence of layers (2), wherein the reflecting sequence of layers (3) includes alternating third layers (3a) and fourth layers (3b), and wherein the reflecting sequence of layers (3) has compressive stress.

2. The method according to claim 1,
wherein, in the mirror (5), the compressive stress generated by the reflecting sequence of layers (3) is reduced or compensated by the tensile stress generated in the stress compensating sequence of layers (2).

3. The method according to claim 1 or 2,
wherein, prior to applying the reflecting sequence of layers (3), an intermediate layer (4) is applied onto the stress compensating sequence of layers (2), which has an rms roughness of no more than 0.2 nm.

4. The method according to claim 3,
wherein the intermediate layer (4) includes boron, a boron nitride, boron carbide, boron oxide or carbon and has a thickness of between 10 nm and 200 nm.

5. The method according to any one of the preceding claims,
wherein the stress compensating sequence of layers (2) includes between 10 and 400 layer pairs of the first layers (2a) and second layers (2b), and wherein the first layers (2a) and second layers (2b) have a thickness of between 1 nm and 10 nm.

6. The method according to any one of the preceding claims,
wherein between the first layers (2a) and the second layers (2b), a barrier layer (2d) is arranged in each case, wherein the barrier layer (2d) includes carbon, molybdenum, ruthenium, zirconium or an oxide, nitride or carbide of molybdenum, ruthenium or zirconium, and wherein the barrier layer (2d) has a thickness of between 0.1 nm and 0.3 nm.

## Revendications

1. Procédé de fabrication d'un miroir (5) de réflexion de rayonnement EUV, comprenant les étapes :
- application d'une succession de couches (2) à compensation d'effort sur un substrat (1), sachant que la succession de couches (2) à compensation d'effort présente des premières couches (2a) et des deuxièmes couches (2b) alternantes, sachant que les premières couches (2a) présentent du bore, un nitrure de bore, un carbure de bore ou un oxyde de bore et les deuxièmes couches (2b) présentent du lanthane, un nitrure de lanthane, un carbure de lanthane ou un oxyde de lanthane, et sachant que la succession de couches (2) à compensation d'effort présente un effort de pression après l'application sur le substrat (1),
- exécution d'un traitement thermique dans la plage de température entre 100 °C et 800 °C, sachant que l'effort de pression est diminué par le traitement thermique et un effort de traction est généré dans la succession de couches (2) à compensation d'effort,
- application d'une succession de couches (3) réfléchissante par-dessus la succession de couches (2) à compensation d'effort, sachant que la succession de couches (3) réfléchissante présente des troisièmes couches (3a) et des quatrièmes couches (3b) alternantes, et sachant que la succession de couches (3) réfléchissante présente un effort de pression.

2. Procédé selon la revendication 1,
sachant que dans le miroir (5), l'effort de pression généré par la succession de couches (3) réfléchissante est réduit ou compensé par l'effort de traction généré dans la succession de couches (2) à compensation d'effort.

3. Procédé selon la revendication 1 ou 2,
sachant qu'avant l'application de la succession de couches (3) réfléchissante, une couche intermédiaire (4) qui présente une rugosité rms de maximum 0,2 nm est appliquée sur la succession de couches (2) à compensation d'effort.

4. Procédé selon la revendication 3,
sachant que la couche intermédiaire (4) présente du bore, un nitrure de bore, un carbure de bore, un oxyde de bore ou du carbone et présente une épaisseur entre 10 nm et 200 nm.

5. Procédé selon l'une des revendications précédentes,
sachant que la succession de couches (2) à compensation d'effort présente entre 10 et 400 paires de couches des premières couches (2a) et deuxièmes couches (2b), et sachant que les premières couches (2a) et deuxièmes couches (2b) présentent une épaisseur entre 1 nm et 10 nm.

6. Procédé selon l'une des revendications précédentes,
sachant qu'entre les premières couches (2a) et les deuxièmes couches (2b), respectivement une couche barrière (2d) est disposée, sachant que la couche barrière (2d) présente du carbone, du molybdène, du ruthénium, de la zircone ou un oxyde, un nitrure ou un carbure de molybdène, de ruthénium ou de zircone, et sachant que la couche barrière (2d) a entre 0,1 nm et 0,3 nm d'épaisseur.
